# EUROPÄISCHE PATENTSCHRIFT

(11) **EP 0 563 102 B1**
(45) Veröffentlichungstag und Bekanntmachung des Hinweises auf die Patenterteilung: **15.06.1994**
(21) Anmeldenummer: 92900756.5
(22) Anmeldetag: 18.12.1991
(51) Int. Cl.: G03C 9/08, B29C 35/08, B44B 1/02, G01S 17/36

(54) **VERFAHREN UND VORRICHTUNG ZUM HERSTELLEN EINES DREIDIMENSIONALEN OBJEKTS**
PROCESS AND DEVICE FOR PRODUCING A THREE-DIMENSIONAL OBJECT
PROCEDE ET DISPOSITIF DE FABRICATION D'OBJETS TRIDIMENSIONNELS

(30) Priorität: 21.12.1990 DE 4041285; 18.04.1991 DE 4112695
(43) Veröffentlichungstag der Anmeldung: 06.10.1993
(73) Patentinhaber: EOS GmbH ELECTRO OPTICAL SYSTEMS, 82152 Planegg (DE)
(72) Erfinder: LANGER, Hans, J., D-8032 Gräfelfing (DE); CABRERA, Miguel, F-69004 Lyon (FR)
(74) Vertreter: Prüfer, Lutz H., Dipl.-Phys.
(86) Internationale Anmeldenummer: EP9102441
(87) Internationale Veröffentlichungsnummer: WO9211577

(56) Entgegenhaltungen:
- EP-A- 0 171 069
- EP-A- 0 388 129
- EP-A- 0 393 672
- EP-A- 0 400 578
- EP-A- 0 450 762
- WO-A-88/06494
- WO-A-90/03255
- US-A- 4 132 575

## Beschreibung

Die Erfindung betrifft ein Verfahren und eine Vorrichtung zur Herstellung eines dreidimensionalen Objekts nach dem Oberbegriff des Anspruchs 1 bzw. des Anspruchs 15.

Ein Beispiel für ein derartiges Verfahren ist unter dem Begriff "Stereographie" oder "Stereolithographie" bekannt und in dem Artikel von Hideo Kodama, "Automatic method for fabricating a three-dimensional plastic model with photo-hardening polymer", Rev.Sci.Instrum. 52(11), Nov. 1981, Seiten 1770 bis 1773, beschrieben. Bei einem derartigen Verfahren tritt das Problem auf, daß eine Maßhaltigkeit des Objekts nicht gewährleistet ist. Der Grund hierfür liegt insbesondere darin, daß die einzelnen Schichten während der Herstellung beim Verfestigen eine Volumenänderung erfahren und damit Spannungen und Formänderungen des gesamten geschichteten Aufbaus bewirken.

Es ist daher Aufgabe der Erfindung, die Genauigkeit bei der Herstellung des Objekts zu verbessern.

Diese Aufgabe wird durch das in Anspruch 1 gekennzeichnete Verfahren bzw. die in Anspruch 8 gekennzeichnete Vorrichtung gelöst.

Gemäß einer vorteilhaften Ausgestaltung der Erfindung erfolgt die Oberflächenmessung des Objekts mittels einer Moiré-Technik, wie sie beispielsweise in der DE-OS 33 28 753 beschrieben ist. Diese Messtechnik hat den Vorteil, daß Ungenauigkeiten der verfestigten Oberfläche des Objekts schnell und berührungslos ermittelt werden können. Ein weiterer besonderer Vorteil ergibt sich hierbei daraus, daß zur Steuerung der Verfestigungsvorrichtung , also der Lichtquelle, üblicherweise ein Rechner vorgesehen ist, der aufgrund eines CAD-Konstruktionsprogrammes auch die Daten des herzustellenden Objekts ermittelt und dem nunmehr auch die gemessenen Oberflächendaten zur Auswertung zugeführt werden können, sodaß dieser Rechner ebenfalls die Korrektur der Objektdaten aufgrund des Meßergebnisses übernehmen kann. Eine zusätzliche Auswerteeinrichtung ist also nicht erforderlich.

Weitere Merkmale und Zweckmäßigkeiten der Erfindung ergeben sich aus der Beschreibung von Ausführungsbeispielen anhand der Figuren. Von den Figuren zeigen
- Fig. 1: eine schematische Ansicht einer ersten Ausführungsform einer Vorrichtung zur Durchführung des erfindungsgemäßen Verfahrens; und
- Fig. 2: eine schematische Ansicht einer zweiten Ausführungsform einer erfindungsgemäßen Vorrichtung.

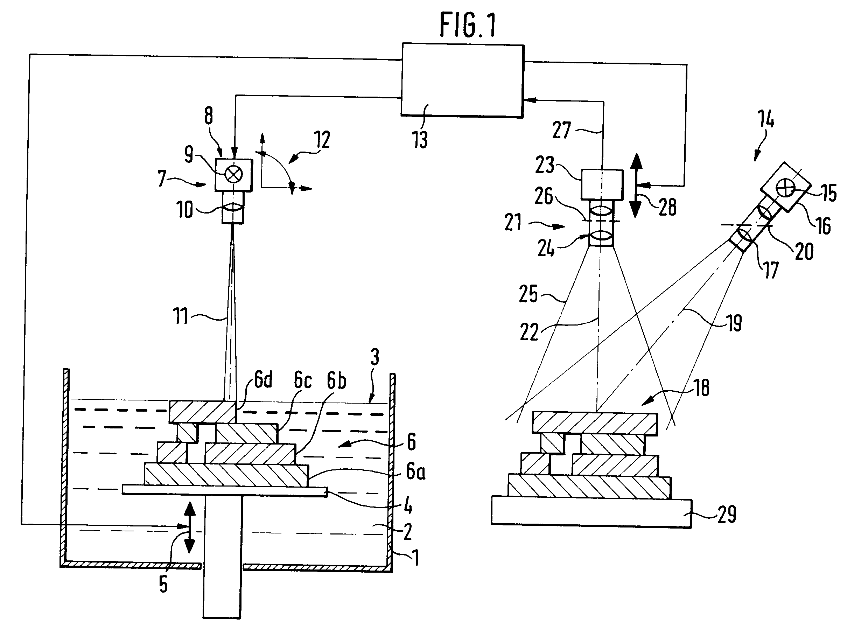

Figur 1 zeigt einen Behälter 1, der mit einem lichthärtbaren, flüssigen Kunststoff 2 bis zu einem Niveau bzw. einer Oberfläche 3 gefüllt ist. Im Behälter befindet sich eine im wesentlichen ebene Trägerplatte 4, die parallel zum Niveau 3 bzw. der Oberfläche des Kunststoffs 2 angeordnet ist und mittels einer Verschiebeeinrichtung 5 senkrecht zur Ebene des Niveaus 3 auf und ab verschoben und positioniert werden kann.

Auf der Trägerplatte 4 befindet sich das Objekt 6, das aus einer Mehrzahl von Schichten 6a, 6b, 6c und 6d, die sich jeweils parallel zum Niveau 3 erstrecken, in der später beschriebenen Weise aufgebaut wird.

Eine Vorrichtung 7 zum Verfestigen der an die Oberfläche 3 angrenzenden obersten Schicht 6d enthält eine Beleuchtungsvorrichtung 8 mit einer Lichtquelle 9, die über eine Optik 10 einen gebündelten Lichtstrahl 11 auf die Oberfläche des Kunststoffs 2 richtet. Als Lichtquelle kommt je nach Art des verwendeten Kunstoffs eine UV-Lichtquelle, ein Laser oder andere Lichtquellen in Frage. Eine Aufhängung bzw. Positioniervorrichtung 12 für die Vorrichtung 7 erlaubt die Bewegung und Schwenkung der Vorrichtung 7 derart, daß der gebündelte Lichtstrahl an jeder Stelle der Oberfläche 3 positioniert werden kann. Diese Positionierung erfolgt durch einen Rechner 13, der mit der Vorrichtung 7 verbunden ist. Zusätzlich kann über diese Ankopplung eine Einstellung der Intensität des Lichtstahls 11 über eine Helligkeitsregelung der Lichtquelle 9 erfolgen.

Eine Meßvorrichtung 14 enthält einen mit einer Lichtquelle 15, z.B. einer Bogenlampe oder einem Laser, ausgerüsteten Projektor 16, der über eine Optik 17 ein Meßfeld 18 beleuchtet. An Stelle von Licht kann allerdings auch jede andere elektromagnetische Strahlung verwendet werden. Im Strahlengang des Projektors 16 entlang der Projektionsrichtung 19 ist eine Modulationsvorrichtung in Form eines Projektionsgitters 20, das vorzugsweise als Strichgitter ausgebildet ist, oder eines Laserinterferometers zur Erzeugung eines Modulationsmusters angeordnet. Aufgrund der Divergenz des Strahlengangs führt das Strichgitter bzw. das Laserinterferometer zu einer Projektion räumlich divergierender Lichtebenen.

Das Meßfeld 18 wird von einer Bildaufnahmeeinrichtung 21 unter einer Betrachtungsrichtung 22, die einen Winkel zur Projektionsrichtung 19 einschließt, betrachtet. Die Bildaufnahmeeinrichtung 21 weist eine Kamera 23, vorzugsweise eine Video-, Fernseh- oder CCD-Kamera, sowie eine Betrachtungsoptik 24 auf, mit der eine Scharfstellung auf eine im Meßfeld 18 angeordnete Oberfläche bzw. die in der später beschriebenen Weise gebildete Oberfläche des Objekts 6 möglich ist. Im Betrachtungsstrahlengang 25 ist ein Referenzgitter 26 angeordnet, das ebenfalls als Strichgitter ausgebildet ist. Die Ebene des Referenzgitters 26 ist vorzugsweise parallel zur Ebene des Projektionsgitters 20 bzw. des Laserinterferometers angeordnet.
Die Bildaufnahmeeinrichtung 21 ist über eine Leitung 27 mit dem Rechner 13 gekoppelt. Ferner ist eine schematisch angedeutete Verschiebevorrichtung 28 vorgesehen, die mit dem Rechner 13 zur Verschiebung und Positionierung der Bildaufnahmeeinrichtung 21 in Richtung senkrecht zum betrachteten Meßfeld 18 verbunden ist.

Im Betrieb werden zunächst im Rechner aufgrund eines Konstruktionsprogrammes oder dgl. Daten über die Form des Objekts 6 erstellt. Diese Daten werden für die Herstellung des Objekts 6 so aufbereitet, daß das Objekt in eine Vielzahl von horizontalen, im Vergleich zur Objektdimension dünnen Schichten zerlegt wird und die Formdaten beispielsweise in Form von Datensätzen, z.B. CAD-Daten, für jede Schicht .... . 6d dieser Vielzahl von Schichten bereitgestellt werden. Die Erstellung und Aufbereitung der Daten für jede Schicht kann dabei vor der Herstellung oder auch gleichzeitig mit der Herstellung jeder Schicht erfolgen.

Der Rechner 13 steuert dann die Verschiebeeinrichtung derart, daß die Trägerplatte 4 bis soweit unter die Oberfläche 3 des flüssigen Kunststoffs 2 angehoben wird, daß zwischen der Oberseite der Trägerplatte 4 und der Oberfläche 3 eine flüssige Schicht des Kunststoffs mit einer der ersten Schicht 6a des Objekts entsprechenden Schichtdicke verbleibt. Anschlieβend wird über die Positioniervorrichtung 12 die Beleuchtungsvorrichtung 8 so gesteuert, daß der Lichtstrahl 11 auf den im Rechner 13 erstellten und aufbereiteten Formdaten entsprechenden Stellen der flüssigen Kunststoffschicht auftrifft. Durch die Einwirkung der Strahlung wird der Kunststoff in bekannter Weise polymerisiert bzw. gehärtet, so daß sich die flüssige Schicht verfestigt.

Nach der Herstellung der ersten Schicht 6a wird die Verschiebeeinrichtung 5 vom Rechner so gesteuert, daß die Trägerplatte 4 um die Dicke der nächsten Schicht nach unten bewegt wird, so daß wiederum eine der Dicke der nächsten Schicht 6b entsprechende Schicht flüssigen Kunststoffs die Oberfläche der ersten Schicht 6a bedeckt. Die Verfestigung dieser Schicht 6b erfolgt in der gleichen Weise wie bei der ersten Schicht 6a. Durch anschließendes Abwärtsbewegen der Trägerplatte 4 und Verfestigen der nachfolgenden Schichten 6c, 6d wird das Objekt fertiggestellt.

Nach der Herstellung wird das Objekt 6 nachbehandelt. Hierzu wird zunächst das Objekt von anhaftenden Resten flüssigen Kunststoffs befreit, beispielsweise durch Anblasen und Trocknen oder mittels geeigneter Lösungsmittel. Danach erfolgt, falls erforderlich, eine Nachhärtung durch Lichteinwirkung. Zur nachfolgenden Messung ist es ferner erforderlich, die Oberfläche so zu behandeln, daß sie matt bzw. diffus reflektierend ist. Dies kann durch Anätzen, Färben, Auftragen einer entsprechenden diffus reflektierenden Schicht oder ähnliche bekannte Mattierverfahren geschehen.

Nach der Nachbehandlung erfolgt die Messung des Objekts 6. Hierzu wird das Objekt 6 in der im rechten Teil der Figur gezeigten Weise auf einem Meßtisch 29 so positioniert, daß seine zu messende Oberfläche im Meßfeld 18 der Meßvorrichtung 14 liegt. Die Oberfläche wird mit dem Projektor 16 beleuchtet und mit der Bildaufnahmeeinrichtung 21 betrachtet, die zu diesem Zweck in ihrem Abstand von der Oberfläche des Objekts bzw. vom Meßtisch 29 justiert wird. Aufgrund der Überlagerung des projizierten Gitters bzw. Modulationsmusters 20 mit dem Referenzgitter 26 ergeben sich auf der Oberfläche Moiré-Linien, die Höhenschichtlinien des Objekts 6 darstellen. Ein Bild dieses Linienmusters wird von der Bildaufnahmeeinrichtung 21 aufgenommen, die für jeden der beispielsweise 512x511 Abtastpunkte einen Grauwert an den Rechner 13 liefert. Dieser rechnet nach bekannten Verfahren (z.B. dem Phasen-Shift-Verfahren; vgl. die DE-OS 33 28 753) die Grauwertverteilung in entsprechende Werte für die Höhe der Objektoberfläche an jeder Meßstelle um, vergleicht sie mit einem Sollwert und errechnet aus diesem Vergleich einen Korrekturwert, der zur Verwendung bei der Herstellung der nachfolgenden Objekte abgespeichert wird.

Bei der Herstellung nachfolgender gleicher Objekte 6 erfolgt nun eine Korrektur aufgrund der abgespeicherten Korrekturwerte. Hierzu werden im Rechner 13 die zu den einzelnen CAD-Daten des Objekts 6 zugehörigen Korrekturwerte der Messung beispielsweise durch eine "best fit"-Analyse zugeordnet. Durch Verknüpfung dieser Korrekturwerte mit den zugehörigen CAD-Daten, beispielsweise durch entsprechende Berücksichtigung der festgestellten Formabweichung des Objekts in Betrachtungsrichtung 22 und in Richtung senkrecht dazu, werden vom Rechner 13 korrigierte CAD-Daten ermittelt und für die Herstellung der nächsten Objekt verwendet. Dies kann alternativ oder zusätzlich auch dadurch geschehen, daß beispielsweise die Schichtdicke der einzelnen Schichten 6a...6d durch Veränderung der Intensität des Lichtstrahls 11, z.B. durch entsprechende Veränderung der Leistung der Lichtquelle 9, oder veränderte Positionierung des Lichtstrahls 11 durch die Positioniervorrichtung 12 an den Stellen, an denen ein vom Sollwert abweichendes Maß des Objekts 6 festgestellt wurde, derart verändert wird, daß dort die Form und Kontur des Objekts wieder einem Sollwert entspricht. Ebenso ist eine Korrektur der Konturmaße bei der Herstellung des nächsten Objekts möglich.

Das Meßverfahren kann auch ohne das Referenzgitter 24 angewendet werden, wenn beispielsweise ein CCD-Chip gleichzeitig als Detektor und Referenzgitter verwendet wird oder ein Phasenmeßprofilometrie- (PMP) oder Phasenmeßtriangulations-(PMT) verfahren verwendet wird, wobei das reflektierte Linienmuster direkt von der Bildaufnahmeeinrichtung 21 durch Vergleich mit einem Referenzmuster ausgewertet werden kann ("Software-Moiré"). Ferner ist für die Messung des Objekts auch jedes andere Meßverfahren geeignet, das eine Bestimmung der Kontur- und Oberflächenmaße des Objekts erlaubt. Beispiele sind mechanische Abtastverfahren oder andere optische Verfahren wie Triangulation oder optisches Radar. Je nach den Erfordernissen dieser Verfahren kann auch die Nachbehandlung zur Erzielung der matten bzw. diffus reflektierenden Oberfläche entfallen.

Das beschriebene Verfahren erlaubt somit eine Korrektur der Herstellung des Objekts in Form eines geschlossenen Regelkreises, die außer den primären Formänderungsursachen, nämlich den durch die Volumenänderung bzw. Schrumpfung beim Verfestigen und/oder Nachhärten auftretenden Spannungen und Formänderungen, sämtliche Ungenauigkeiten wie z.B. Justierfehler der Beleuchtungsvorrichtung, Unregelmäßigkeiten des Kunststoffs, Schwankungen in der Höheneinstellung der Trägerplatte etc. berücksichtigt.

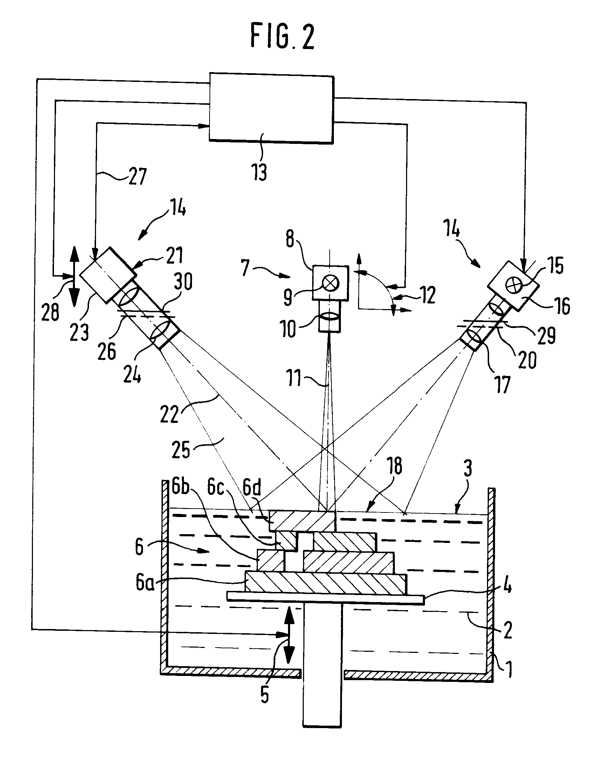

Bei der in Figur 2 gezeigten Vorrichtung sind der Figur 1 entsprechende Teile mit den gleichen Bezugszeichen versehen. Diese Vorrichtung unterscheidet sich von der nach Figur 1 im wesentlichen dadurch, daß die Meßvorrichtung 14 so mit der Verfestigungsvorrichtung 7 kombiniert ist, daß das Meßfeld 18 in der Oberfläche 3 im Bereich der zu verfestigenden Schichten des Objekts 6 liegt. Um die bei der Moiré-Messung störende spiegelnde Reflexion an der Oberfläche 3 zu vermeiden, wird die Moiré-Messung mit Fluoreszenz- oder Phosphoreszenz-Strahlung durchgeführt. Zu diesem Zweck besitzt der Kunststoff 2 eine fluoreszierende oder phosphoreszierende Eigenschaft bzw. ein Farbstoff mit einer derartigen Eigenschaft ist dem Kunststoff 2 zugemischt, und die Beleuchtung durch die Lichtquelle 15 erfolgt mit einer die Fluoreszenz oder Phosphoreszenz anregenden Wellenlänge. Beispielsweise kann hierfür eine UV-Lichtquelle oder in der in Figur 2 gezeigten Weise ein nur oder bevorzugt die Anregungswellenlänge, beispielsweise UV-Strahlung, durchlassendes Filter 29 im Beleuchtungsstrahlengang vorgesehen sein. Entsprechend ist im Betrachtungsstrahlengang 25 ein Filter 30 vorgesehen, das nur oder bevorzugt die Fluoreszenz- oder Phosporeszenzstrahlung des Kunststoffs oder Farbstoffs passieren läßt.

Mit der Vorrichtung nach Figur 2 wird zunächst nach der Verfestigung einer Schicht und dem darauffolgenden Absenken der Trägerplatte um ein der nächsten Schichtdicke entsprechendes Maß die Oberfläche des noch flüssigen Kunststoffs gemessen und mit im Rechner 13 gespeicherten Werten verglichen. Diese Messung wird in kurz aufeinanderfolgenden Zeitabschnitten wiederholt, bis im Rechner festgestellt wird, daß die Schichtdicke der flüssigen Schicht und ihre Unebenheiten innerhalb der vorgegebenen Toleranzwerte liegt. Dann wird die Verfestigung einer Schicht freigegeben, die in gleicher Weise wie bei der Vorrichtung nach Figur 1 erfolgt. Dies hat den Vorteil, daß jeweils die kürzestmögliche Wartezeit vor dem Verfestigen bestimmt und eingehalten werden kann. Zur Beschleunigung kann zusätzlich und vor oder nach der Messung der Oberfläche der flüssigen Schicht eine Absenkung der Trägerplatte 4 unter das der nächsten Schicht entsprechende Niveau erfolgen und die sich damit einstellende dickere flüssige Schicht mit einer (nicht gezeigten) Wischvorrichtung, die horizontal über die Oberfläche 3 bewegt wird, auf das korrekte Maß reduziert werden.

Im Unterschied zur Ausführungsform nach Figur 1 wird das Objekt 6 zur Messung nicht aus dem Kunststoffbad 2 herausgenommen, sondern die Messung der verfestigten Oberfläche und der Kontur der Schicht erfolgt direkt im Bad selbst an der Oberfläche 3, vorzugsweise jeweils nach dem Verfestigen einer Schicht. Dies ist möglich, weil die angeregte Fluoreszenz- oder Phosphoreszentstrahlung des Kunststoffs diffus abstrahlt und durch das Filter 30 die spiegelnden Strahlungsanteile ausgeblendet werden. Der Zeitaufwand für die Nachbehandlung des Objekts 6 vor der Messung entfällt damit. Ferner wird erfindungsgemäß eine bei der Messung der Schicht festgestellte Unregelmäßigkeit der Oberfläche oder der Kontur der Schicht direkt an den Rechner übermittelt, der daraufhin die Formdaten der nachfolgenden Schicht zum Ausgleich dieser Abweichungen entsprechend korrigiert, sodaß eine Korrektur des Objekts 6 selbst und nicht nur eine Korrektur nachfolgender gleicher Objekte möglich ist.

Bei der Messung der Kontur des verfestigten Objekts muß der den verfestigten Bereich vom flüssigen Kunststoff trennende Rand mit der gewünschten Auflösung bzw. Genauigkeit erkannt werden. Dies ist mit dem oben beschriebenen Meßverfahren möglich, da sich die Breite des Fluoreszenzbandes der reflektierten Strahlung abhängig vom Phasenzustand des Kunststoffs ändert und verschiebt. Mittels eines wellenlängenselektiven Empfängers kann also unterschieden werden, ob an einer bestimmten Stelle ein flüssiger oder verfestigter Kunststoff vorliegt. Alternativ ist es natürlich auch möglich, das Objekt nach der Verfestigung jeder Schicht kurz soweit über die Oberfläche 3 anzuheben, daß die zu messende Schicht oberhalb der Oberfläche 3 liegt.

Um eine für die Konturmessung erforderliche Meßgenauigkeit im gesamten Bereich der Oberfläche 3 mit vertretbarem Aufwand zu erreichen, kann die Meßvorrichtung 14 auch als ein beweglicher Meßkopf ausgebildet sein, der zur Messung nach Art eines Scanning über die Oberfläche der verfestigten Schicht 6a...d bewegt wird und diese damit bereichsweise abtastet.

Abwandlungen der beschriebenen Vorrichtungen und Verfahren sind möglich. So kann beispielsweise die Verfestigung des Kunststoffs abhängig von dessen Eigenschaften auch durch jede andere Form von elektromagnetischer Strahlung, durch Wärme oder chemische Einwirkung oder durch deren Kombination erfolgen. Die Schichtdicke des flüssigen Kunststoffs vor der Verfestigung kann anstatt durch Absenken der Trägerplatte 4 auch durch entsprechend veränderliche Einstellung bzw. ein Anheben des Niveaus 3 mittels Pumpen, Verdrängern oder dgl. bei feststehender Trägerplatte oder durch Aufbringen einer definierten Schichtdicke auf der verfestigten Oberfläche beispielsweise durch Aufsprühen erfolgen. Die Messung der Oberflächenkoordinaten kann auch mit anderen bekannten optischen Verfahren wie z.B. der Laserinterferometrie oder der Laserabtastung mittels phasenmodulierter Laufzeitverfahren (Laserradar) erfolgen. Insbesondere kann die Bestimmung, ob die Oberfläche des flüssigen Kunststoffs vor der Verfestigung einer Schicht gleichmäßig und horizontal ist, auch durch einfache optische Reflexionsmessungen erfolgen. Hierbei wird das bei unebener oder schräger Oberfläche veränderte Reflexionsbild, beispielsweise bei Beleuchtung unter einem schrägen Winkel, erfaßt.

Der Meßtisch kann ferner kardanisch so aufgehängt sein, daß er eine Betrachtung und Messung des Objekts 6 von allen Seiten ermöglicht. Ferner ist es auch bei der Vorrichtung nach Figur 1 möglich, die Meßvorrichtung 14 in die Herstellung zu integrieren. Hierzu ist die Meßvorrichtung 14 so angeordnet, daß sie das Objekt 6 in einer Stellung messen kann, in der dieses durch die Trägerplatte 4 aus dem Bad des Kunststoffs 2 über die Oberfläche 3 hinausgehoben ist. In diesem Fall erübrigt sich der Transport des Objekt von der Trägerplatte 4 zum Meßtisch 29.

Die Erfindung ist auch nicht auf flüssige Kunststoffe beschränkt. So können beispielsweise auch Kunststoff- oder Metallpulver anstelle des flüssigen Kunststoffs verwendet werden und durch Licht- oder Lasereinwirkung gesintert werden (Lasersintern).

Die Erfindung erlaubt somit eine genaue Herstellung von Modellen und Werkstücken durch Modellierung mittels Licht- oder Lasereinwirkung. Besonders vorteilhaft ist dabei die Herstellung von größeren Serien, da dann die Maßkorrektur nur einmal zu Beginn bzw. wenige Male zwischendurch erfolgen muß.

## Patentansprüche

1. Verfahren zur Herstellung eines dreidimensionalen Objekts durch Verfestigen übereinanderliegender Schichten des Objekts, wobei auf einer bereits verfestigten Schicht eine nachfolgende Schicht aus zunächst flüssigem oder pulverförmigem, durch Lichteinwirkung verfestigbarem Material entsprechend der Form des Objekts verfestigt wird, dadurch gekennzeichnet, daß die Oberfläche und/oder die Kontur des Objekts gemessen und das Meßergebnis mit vorgegebenen Daten des Objekts verglichen wird und daß aus dem Vergleich Korrekturwerte für die Herstellung ermittelt werden.

2. Verfahren nach Anspruch 1, dadurch gekennzeichnet, daß die Oberflächenmessung dadurch erfolgt, daß auf die Oberfläche ein erstes Modulationsmuster projiziert wird, die Oberfläche über ein zweites Modulationsmuster unter einem Winkel zur Projektionsrichtung betrachtet wird und aus dem sich durch die Überlagerung der beiden Modulationsmuster ergebenden Linienmuster Koordinaten der Oberfläche bestimmt werden.

3. Verfahren nach Anspruch 1 oder 2,
dadurch gekennzeichnet, daß die Messung nach der Verfestigung einer Schicht erfolgt und die ermittelten Korrekturwerte bei der Verfestigung der nachfolgenden Schicht verwendet werden.

4. Verfahren nach einem der Ansprüche 1 bis 3,
dadurch gekennzeichnet, daß die Verfestigung in einem Bad aus zumindest teilweise fluoreszierendem oder phosphoreszierendem Material erfolgt und die Messung des Objekts nach der Verfestigung einer Schicht im Bad selbst durch Betrachtung in einem Wellenlängenbereich der Fluoreszenz- oder Phosphoreszenzstrahlung erfolgt.

5. Verfahren nach einem der Ansprüche 1 bis 3,
dadurch gekennzeichnet, daß das Objekt vor der Messung nachgehärtet wird.

6. Verfahren nach einem der Ansprüche 2 bis 5,
dadurch gekennzeichnet, daß vor der Verfestigung einer Schicht die Oberfläche der noch unverfestigten Schicht zur Feststellung von Unebenheiten gemessen wird und daß die Verfestigung erst freigegeben wird, wenn die Unebenheiten der Oberfläche unter einem vorgegebenen Schwellenwert liegen.

7. Verfahren nach einem der Ansprüche 1 bis 6,
dadurch gekennzeichnet, daß die Korrekturwerte mit den vorgegebenen Daten zur Bestimmung von korrigierten Objektdaten für die Herstellung nachfolgender Objekte verknüpft werden.

8. Vorrichtung zur Durchführung des Verfahrens nach Anspruch 1, mit einer Vorrichtung (1, 2, 4) zum Erzeugen aufeinanderfolgender Schichten eines flüssigen oder pulverförmigen, durch Lichteinwirkung verfestigbaren Materials (2) und einer Vorrichtung (7) zum definierten Verfestigen jeder dieser Schichten entsprechend der Form des herzustellenden Objekts,
dadurch gekennzeichnet, daß eine Meßvorrichtung (14) zum Abtasten des Objekts und eine Vorrichtung (13) zum Vergleich der Meßdaten mit vorgegebenen Daten der Schicht vorgesehen ist und daß die Meßvorrichtung (14) und die Vergleichsvorrichtung (13) mit der Verfestigungsvorrichtung (7) zur Steuerung derselben in Abhängigkeit von dem von der Meßvorrichtung (14) ermittelten Meßergebnis verbunden sind.

9. Vorrichtung nach Anspruch 8, dadurch gekennzeichnet, daß die Meßvorrichtung (14) und die Verfestigungsvorrich-tung (7) mit einem Rechner (13) verbunden sind, der Datensätze des Objekts erstellt, mit den von der Meßvor-richtung (14) gelieferten Oberflächendaten vergleicht und daraus korrigierte Objektdaten ermittelt und die Verfestigungsvorrichtung (13) in Abhängigkeit der korrigierten Objektdaten steuert.

10. Vorrichtung nach Anspruch 8 oder 9, dadurch gekennzeichnet, daß die Meßvorrichtung (14) eine Vorrichtung (15, 16) zur Beleuchtung des Objekts, eine Aufnahmeeinrichtung (21) zur Betrachtung des Objekts unter einem Winkel zur Beleuchtungsrichtung, ein erstes Gitter (20) im Beleuchtungsweg und vorzugsweise ein zweites Gitter (26) im Betrachtungsweg sowie eine mit der Aufnahmeeinrichtung verbundene Auswerteeinrichtung (13) aufweist.

11. Vorrichtung nach einem der Ansprüche 8 bis 10,
dadurch gekennzeichnet, daß die Verfestigungsvorrichtung (7) eine Lichtquelle (9) zur Erzeugung eines gebündelten Lichtstrahls (11) und eine Steuervorrichtung (12, 13) zum Steuern der Position des Lichtstrahls (11) über die Fläche der zu verfestigenden Schicht und zur Einstellung der Intensität des Lichtstrahls aufweist.

12. Vorrichtung nach Anspruch 10 oder 11,
dadurch gekennzeichnet, daß die Beleuchtungsvorrichtung (15, 16) das Objekt mit einer eine Fluoreszenz oder Phosphoreszenz des Materials (2) anregenden Strahlung beleuchtet und daß die Aufnahmeeinrichtung (21) auf die Fluoreszenz- oder Phosphoreszenzstrahlung des Materials (2) abgestimmt ist.

13. Vorrichtung nach Anspruch 12,
dadurch gekennzeichnet, daß die Aufnahmeeinrichtung (21) einen wellenlängenselektiven Empfänger zur Feststellung einer Verschiebung bzw. Änderung der Breite des Fluoreszenz- oder Phosphoreszenzbandes aufweist.

## Claims

1. Method for production of a three-dimensional object by solidifying superposed layers of the object, wherein on an already solidified layer a subsequent layer of initially liquid or powdery material which is solidifiable by action of light is solidified corresponding to the shape of the object,
characterized in that the surface and/or the contour of the object is measured and the measurement result is compared with predetermined data of the object and that correction data for the manufacture are determined on the basis of this comparison.

2. Method according to claim 1,
characterized in that the surface measurement is made by projecting a first modulation pattern onto the surface, viewing the surface at an angle with respect to the direction of projection through a second modulation pattern and determining coordinates of the surface based on the line pattern resulting from the interference of both modulation patterns.

3. Method according to claim 1 or 2,
characterized in that the measurement is made after solidifying a layer and the determined correction data are used when solidifying the following layer.

4. Method according to any of the claims 1 to 3,
characterized in that the measurement is made within a bath of at least partially fluorescent or phosphorescent material and the object is measured within the bath after solidifying a layer, by observation within a wave length region of the fluorescent or phosphorescent radiation.

5. Method according to any of the claims 1 to 3,
characterized in that the object is postcured before the measurement.

6. Method according to any of the claims 2 to 5,
characterized in that before solidifying a layer the surface of the unsolidified layer is measured for detecting unevenness, and that the solidification is enabled only if the unevenness of the surface is below a predetermined threshold value.

7. Method according to any of the claims 1 to 6,
characterized in that the correction data are combined with the predetermined data for determining corrected object data for the production of following objects.

8. Apparatus for carrying out the method of claim 1, comprising means (1, 2, 4) for generating superposed layers of a liquid or a powdery material (2) which can be solidified by action of light, and means (7) for controlled solidification of each of these layers in correspondence with the shape of the object to be produced,
characterized in that a measuring appliance (14) for scanning the object and means (13) for comparing the measurement data with predetermined data of the layer are provided and that the measuring appliance (14) and the comparing means (13) are coupled with the solidifying means (7) for control thereof in response to the measuring result determined by the measuring applicance (14),

9. Apparatus according to claim 8,
characterized in that the measuring appliance and the solidifying means (7) are coupled to a computer (13) which generates data sets of the object, compares those data sets with the surface data supplied by the measuring appliance (14) and determines corrected object data therefrom, and which controls the solidifying means (13) in response to the corrected object data.

10. Apparatus according to claim 8 or 9,
characterized in that the measuring appliance (14) comprises means (15, 16) for illuminating the object, an image recording means (21) for viewing the object at an angle with respect to the direction of illumination, a first grating (20) in the course of the illuminating beam and preferably a second grating (26) in the course of the viewing beam as well as evaluation means (13) coupled to the recording means.

11. Apparatus according to any of the claims 8 to 10,
characterized in that the solidifying means comprises a light source (9) for generating a focussed light beam (11) and control means for controllably moving the position of the light beam (11) across the area of the layer to be solidified and for adjusting the intensity of the light beam.

12. Apparatus according to claims 10 or 11,
characterized in that the illumination means (15, 16) illuminates the object using a radiation which stimulates fluorescence or phosphorescence of the material (2) and that the recording means (21) is tuned to the fluorescent or phosphorescent radiation of the material (2).

13. Apparatus according to claim 12,
characterized in that the recording means (21) comprises a wave length selective receiver for determining a shift or variation of the width of the fluorescent or phosphorescent band.

## Revendications

1. Procédé pour la fabrication d'un objet tridimensionnel par durcissement de couches superposées de l'objet, selon lequel une couche suivante, constituée d'un matériau tout d'abord liquide ou pulvérulent, durcissable par action de la lumière, est durcie selon la forme de l'objet, sur une couche déjà durcie, caractérisé en ce que la surface et/ou les contours de l'objet sont mesurés et le résultat de la mesure est comparé à des valeurs prédéterminées de l'objet, et en ce qu'à partir de cette comparaison sont déterminées des valeurs de correction pour la fabrication.

2. Procédé selon la revendication 1, caractérisé en ce que la mesure de surface est assurée par une première projection d'une modulation de référence, et en ce que la surface est observée au travers d'une deuxième modulation de référence, avec un angle par rapport à la direction de la projection, les lignes de base en résultant du fait de la superposition des deux modulations de référence, permettant de déterminer les coordonnées de la surface.

3. Procédé selon la revendication 1 ou 2, caractérisé en ce que la mesure est effectuée après le durcissement d'une couche et en ce que les valeurs de correction calculées sont utilisées lors du durcissement de la couche suivante.

4. Procédé selon l'une des revendications 1 à 3, caractérisé en ce que le durcissement dans un bain est effectué avec un matériau au moins partiellement fluorescent ou phosphorescent, et en ce que la mesure de l'objet après le durcissement d'une couche dans le bain même, est effectuée par une observation dans une plage de longueurs d'onde du rayonnement fluorescent et phosphorescent.

5. Procédé selon l'une des revendications 1 à 3, caractérisé en ce que l'objet subit un durcissement complémentaire avant la prise de mesure.

6. Procédé selon l'une des revendications 2 à 5, caractérisé en ce qu'avant le durcissement d'une couche, la surface de la couche encore non durcie est mesurée pour établir l'existence d'irrégularités, et en ce que le durcissement n'est autorisé que lorsque les irrégularités de la surface se trouvent sous une valeur de seuil prédéterminée.

7. Procédé selon l'une des revendications 1 à 6, caractérisé en ce que les valeurs de correction sont combinées avec les valeurs prédéterminées, à fin de détermination de valeurs corrigées de l'objet, pour la fabrication des objets suivants.

8. Dispositif pour l'application du procédé selon la revendication 1, comprenant un dispositif (1, 2, 4) pour la production de couches consécutives d'un matériau (2), durcissable par action de la lumière, liquide ou pulvérulent, et un dispositif (7) pour le durcissement défini de chacune de ces couches selon la forme de l'objet à fabriquer, caractérisé en ce qu'il est prévu un dispositif de mesure (14) pour l'exploration de l'objet et un dispositif (13) pour la comparaison des données de mesure avec des données prédéterminées, et en ce que le dispositif de mesure (14) et le dispositif de comparaison (13) sont reliés au dispositif de durcissement (7), pour la commande de celui-ci, en fonction du résultat transmis par le dispositif de mesure (14).

9. Dispositif selon la revendication 8, caractérisé en ce que le dispositif de mesure (14) et le dispositif de durcissement (7) sont reliés à un ordinateur (13), qui prépare des enregistrements de données, qui les compare avec les données de surface fournies par le dispositif de mesure (14), et en déduit des données corrigées de l'objet, et commande le dispositif de durcissement (13) en rapport avec les données corrigées de l'objet.

10. Dispositif selon les revendications 8 ou 9, caractérisé en ce que le dispositif de mesure (14) comporte un dispositif (15, 16) pour l'éclairage de l'objet, un dispositif de prise de vues (21) pour l'observation de l'objet sous un angle par rapport à l'axe d'éclairage, une première grille (20) disposée sur le chemin de l'éclairage, et de préférence une deuxième grille (26) sur le chemin de l'observation, de même qu'un dispositif d'exploitation (13) relié avec le dispositif de prise de vues.

11. Dispositif selon l'une des revendications 8 à 10, caractérisé en ce que le dispositif de durcissement (7) comporte une source de lumière (9) pour l'obtention d'un faisceau lumineux (11) et un dispositif de commande (12, 13) pour la commande de la position du faisceau lumineux (11) par-dessus la couche à durcir et pour régler l'intensité du faisceau lumineux.

12. Dispositif selon les revendications 10 ou 11, caractérisé en ce que le dispositif d'éclairage (15, 16) éclaire l'objet avec un faisceau de lumière qui active la fluorescence ou la phosphorescence du matériau (2), et en ce que le dispositif de prise de vues (21) est réglé par rapport au rayonnement fluorescent et phosphorescent du matériau (2).

13. Dispositif selon la revendication 12, caractérisé en ce que le dispositif de prise de vues (21) comporte un récepteur sélectif de longueurs d'onde, pour le constat d'un décalage ou du changement de la largeur de la bande de fluorescence ou phosphorescence.
